# EUROPEAN PATENT APPLICATION

(11) **EP 1 689 054 A1**
(43) Date of publication of application: **09.08.2006**
(21) Application number: 06002161.5
(22) Date of filing: 02.02.2006
(51) Int. Cl.: H01S 5/022, H01S 5/024, G11B 7/22

(54) **Semiconductor laser holder**

(30) Priority: 02.02.2005 JP 2005000428
(71) Applicant: Funai Electric Co., Ltd., Daito-shi, Osaka 574-0031 (JP)
(72) Inventor: Nakamura, Hiroki, Daito-shi, Osaka 574-0013 (JP)
(74) Representative: Beetz & Partner

(57) **Abstract**

In a semiconductor laser holder for holding a frame-type semiconductor laser composed of a frame plate (21) formed of metal and having a laser element (23) mounted on the top face thereof and a frame package formed of resin, formed so as to surround the laser element (23) from the front, rear, left and right sides thereof, and having a light-exit opening formed at the front end thereof to let laser light from the laser element (23) exit therethrough, the semiconductor laser holder (1) has an upper holder member (2) and a lower holder member (3) formed of metal, fitted together from above and below, having housing depressions (4, 5) formed in the fitting faces thereof to house the semiconductor laser (20), and having an opening at the front end thereof to let the laser light exit therethrough. The lower holder member (3) has depressions formed in the fitting face thereof to accommodate heat-sink projections (21a) of the frame plate (21) protruding from the left and right edges of the frame package of the semiconductor laser (20), and the upper holder member (2) has elevations (7) formed on the fitting face thereof to fit into the depressions so as to hold the heat-sink projections (21 a) against the floor faces of the depressions (8).

## Description

### BACKGROUND OF THE INVENTION

### 1. Field of the Invention

The present invention relates to a semiconductor laser holder for holding a semiconductor laser incorporated as a light source in an optical pickup apparatus for reproducing information from and recording information to an optical disc such as a CD or DVD as a recording medium. More particularly, the present invention relates to a semiconductor laser holder for holding a frame-type semiconductor laser.

### 2. Description of Related Art

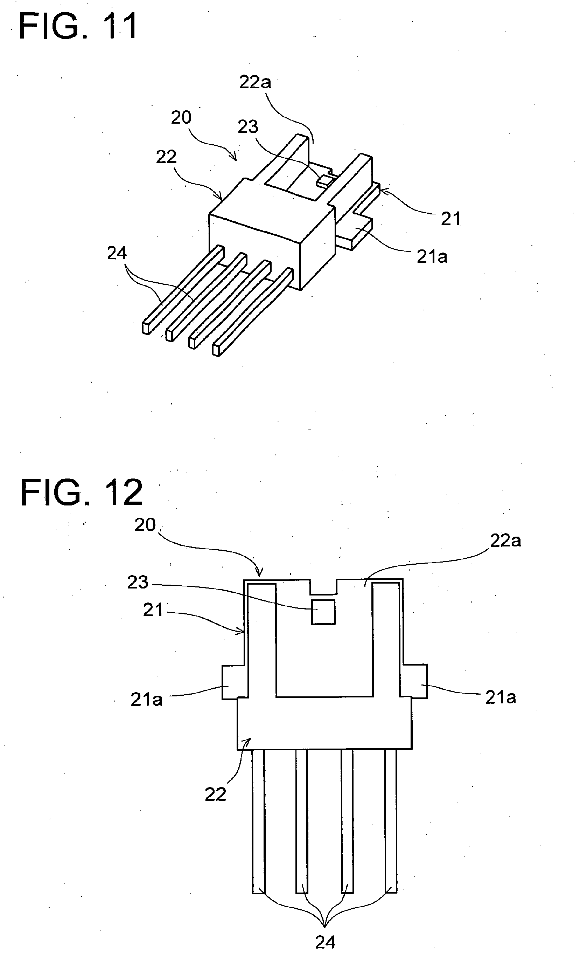

In recent years, as semiconductor lasers, frame-type semiconductor lasers have been increasingly used because of its compactness and low cost. Now, a typical structure of such a frame-type semiconductor laser (hereinafter also referred to simply as "semiconductor laser") will be described with reference to Figs. 11 and 12. As shown in Figs. 11 and 12, the semiconductor laser 20 is roughly composed of: a frame plate 21 that is made of metal and on the top face of which a laser element 23 and a photosensor (unillustrated) are mounted; and a frame package 22 that encloses the laser element 23 from the front, rear, left, and right sides thereof. The frame package 22 is widely open upward, and has a light-exit opening 22a formed at the front end thereof to permit the emission of laser light from the laser element 23. From the left and right edges of the frame package 22, heat-sink projections 21a of the frame plate 21 protrude outward. These heat-sink projections 21a permit the heat generated by the laser element 23 and conducted via the frame plate 21 to be dissipated to outside. From the rear end of the frame package 22, a plurality of lead pins 24 protrude outward.

This semiconductor laser 20, since its laser element 23 is exposed to outside, is usually held in a semiconductor laser holder, and this semiconductor laser holder is fitted to the base member of an optical pickup apparatus. If the semiconductor laser 20 is fitted directly to the base member of an optical pickup apparatus, dust and other foreign matter that managed to enter the optical pickup apparatus may float around or settle on the laser element 23, adversely affecting the accuracy of the laser light. This can be prevented when the semiconductor laser 20 is fitted via a semiconductor laser holder.

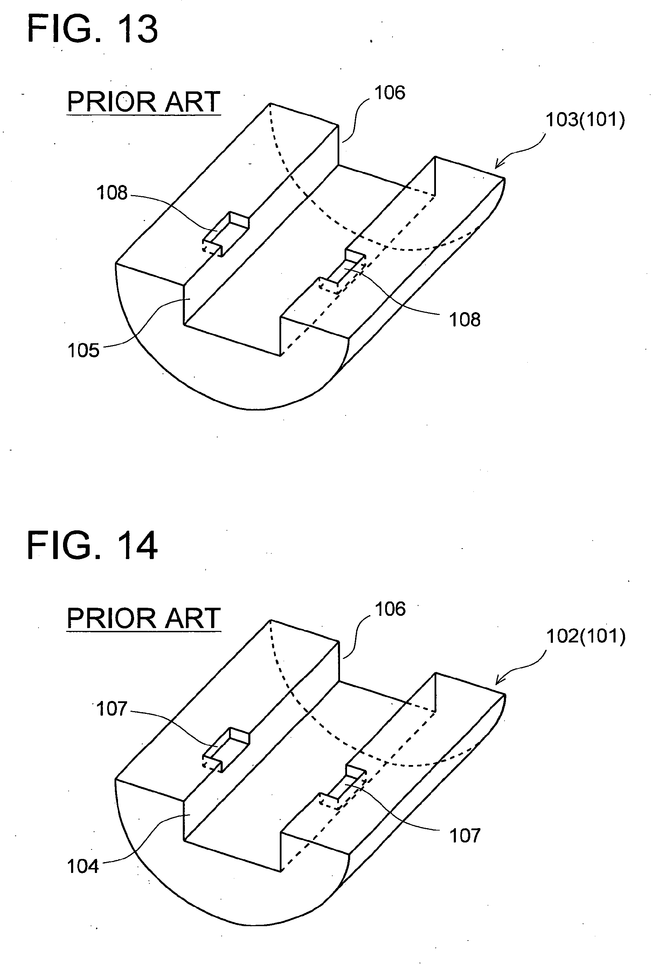

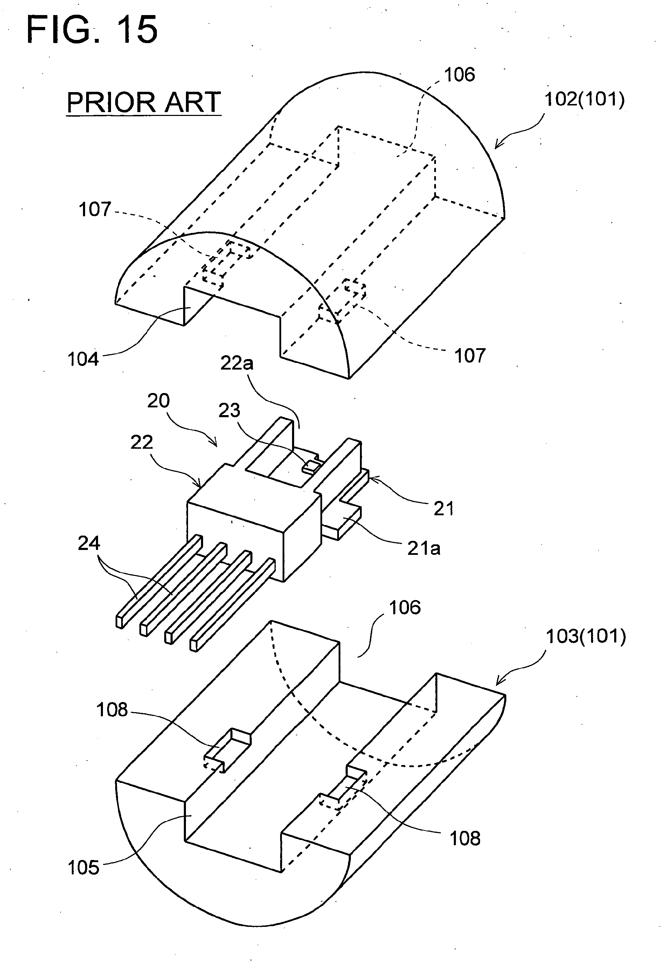

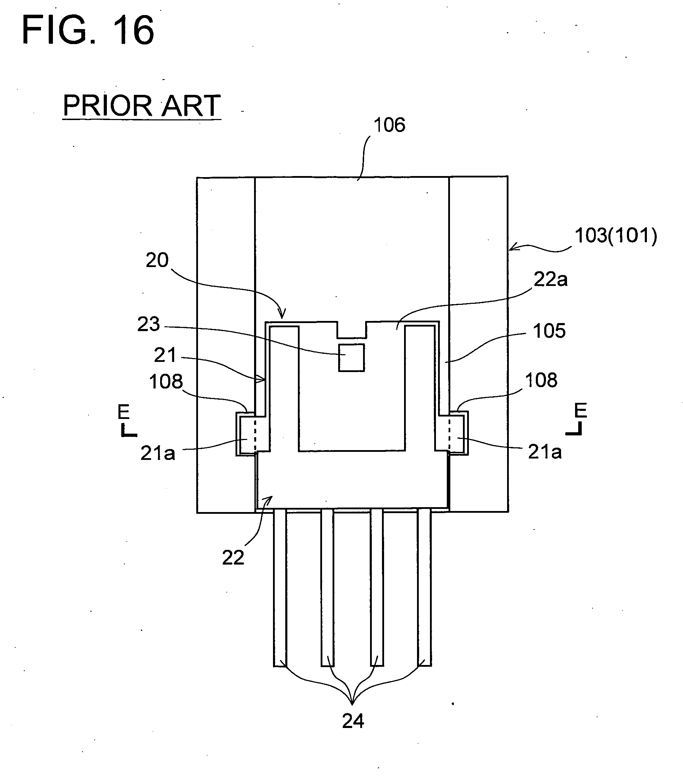

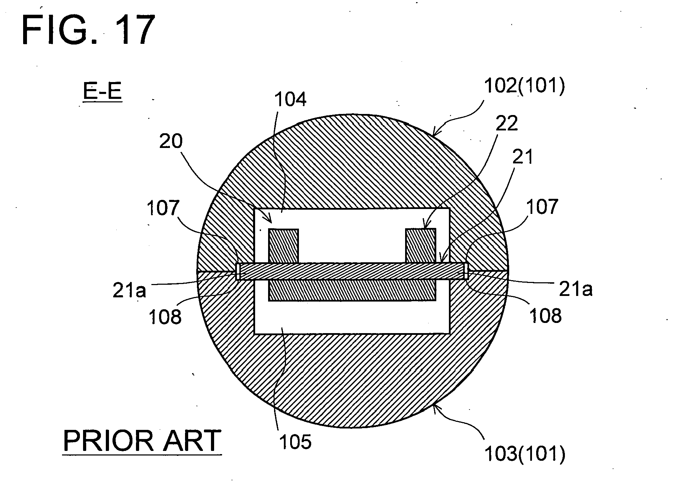

Now, a conventional semiconductor laser holder used for that purpose will be described with reference to Figs. 13 to 17. As shown in Figs. 13 to 17, the conventional semiconductor laser holder 101 is composed of a pair of holder members, namely an upper holder member 102 and a lower holder member 103, that are fitted together from above and below. These upper and lower holder members 102 and 103 have housing depressions 104 and 105 formed in the faces thereof at which they are fitted together, and the semiconductor laser 20 is housed in those housing depressions 104 and 105. The laser light emitted from the laser element 23 through the light-exit opening 22a of the semiconductor laser 20 exits from the housing depressions 104 and 105 through an opening 106 at the front end thereof. In the faces of the upper and lower holder members 102 and 103 at which they are fitted together, depressions 107 and 108 are formed to accommodate the heat-sink projections 21a of the frame plate 21 of the semiconductor laser 20. As a result of the heat-sink projections 21 a held between the floor faces of the depressions 107 and 108, the semiconductor laser 20 is held inside the semiconductor laser holder 101. See, for example, JP A 2004-192720.

Disadvantageously, however, the conventional semiconductor laser holder 101 described above suffers from poor heat dissipation, because the heat-sink projections 21a of the frame plate 21 of the semiconductor laser 20 are covered with the upper and lower holder members 102 and 103. Incidentally, JP A 2004-192720 mentioned above attempts to improve heat dissipation by holding only part of the heat-sink projections 21a between the upper and lower holder members 102 and 103 while leaving the rest of the heat-sink projections 21a protruding from the upper and lower holder members 102 and 103. This, however, cannot be said to promise much.

### SUMMARY OF THE INVENTION

In view of the conventionally experienced disadvantages mentioned above, it is an object of the present invention to provide a semiconductor laser holder that can hold a frame-type semiconductor laser without spoiling heat dissipation.

To achieve the above object, according to the present invention, a semiconductor laser holder for holding a frame-type semiconductor laser composed of a frame plate formed of metal and having a laser element mounted on the top face thereof and a frame package formed of resin, formed so as to surround the laser element from the front, rear, left, and right sides thereof, and having a light-exit opening formed at the front end thereof to let laser light from the laser element exit therethrough is provided with an upper holder member and a lower holder member formed of metal, fitted together from above and below, having housing depressions formed in the fitting faces thereof to house the semiconductor laser, and having an opening at the front end thereof to let the laser light exit therethrough. Here, the lower holder member has depressions formed in the fitting face thereof to accommodate heat-sink projections of the frame plate protruding from the left and right edges of the frame package of the semiconductor laser, and the upper holder member has elevations formed on the fitting face thereof to fit into the depressions so as to hold the heat-sink projections against the floor faces of the depressions.

With this structure, the upper and lower holder members, in which elevations and depressions between which to hold the heat-sink projections of the frame plate of the semiconductor laser are formed, are formed of metal having high thermal conductivity. Thus, the heat generated by the laser element and conducted via the frame plate to the heat-sink projections is conducted further to the upper and lower holder members themselves so as to be then dissipated to outside. In addition, the elevations and depressions formed in the upper and lower holder members serve to hold, between them, the heat-sink projections, and also serve to position the upper and lower holder members relative to each other.

For practical reasons, it is preferable that the upper and lower holder members be formed of zinc.

For stable holding of the semiconductor laser by the upper and lower holder members, it is preferable that the upper and lower holder members that have been fitted together be fixed together by being bonded together with adhesive applied to the fitting faces thereof. Alternatively, it is preferable that the upper and lower holder members that have been fitted together be fixed together by being fastened together with a screw.

For the purpose of preventing undesirable entry of dust and other foreign matter into the holding depressions through the opening at the front end of the upper and lower holder members, it is preferable that, in the housing depressions formed in the upper and lower holder members, a diffraction grating be housed near the opening.

In a case where the semiconductor laser intrinsically has a large astigmatic difference, for the correction of the astigmatic difference, it is preferable that the diffraction grating be so housed as to be inclined at a predetermined angle relative to the optical axis of the laser light.

### BRIEF DESCRIPTION OF THE DRAWINGS

Fig. 1 is a perspective view of the lower holder member constituting the semiconductor laser holder of a first embodiment of the present invention;
Fig. 2 is a perspective view of the upper holder member constituting the semiconductor laser holder of the first embodiment;
Fig. 3 is a perspective view showing the exploded state of the semiconductor laser holder of the first embodiment;
Fig. 4 is a,perspective view showing the assembled state of the semiconductor laser holder of the first embodiment;
Fig. 5 is a top view showing the assembled state of the semiconductor laser holder of the first embodiment;
Fig. 6 is a sectional view along line A-A shown in Fig. 5;
Fig. 7 is a sectional view along line B-B shown in Fig. 5;
Fig. 8 is a perspective view of the lower holder member constituting the semiconductor laser holder of a second embodiment of the present invention;
Fig. 9 is a perspective view of the upper holder member constituting the semiconductor laser holder of the second embodiment;
Fig. 10 is a top view showing the assembled state of the semiconductor laser holder of the second embodiment;
Fig. 11 is a perspective view showing a frame-type semiconductor laser;
Fig. 12 is a top view showing the frame-type semiconductor laser;
Fig. 13 is a perspective view of the lower holder member constituting a conventional semiconductor laser holder;
Fig. 14 is a perspective view of the upper holder member constituting the conventional semiconductor laser holder;
Fig. 15 is a perspective view showing the exploded state of the conventional semiconductor laser holder;
Fig. 16 is a perspective view showing the assembled state of the conventional semiconductor laser holder; and
Fig. 17. is a sectional view along line E-E shown in Fig. 16.

### DETAILED DESCRIPTION OF PREFERRED EMBODIMENTS

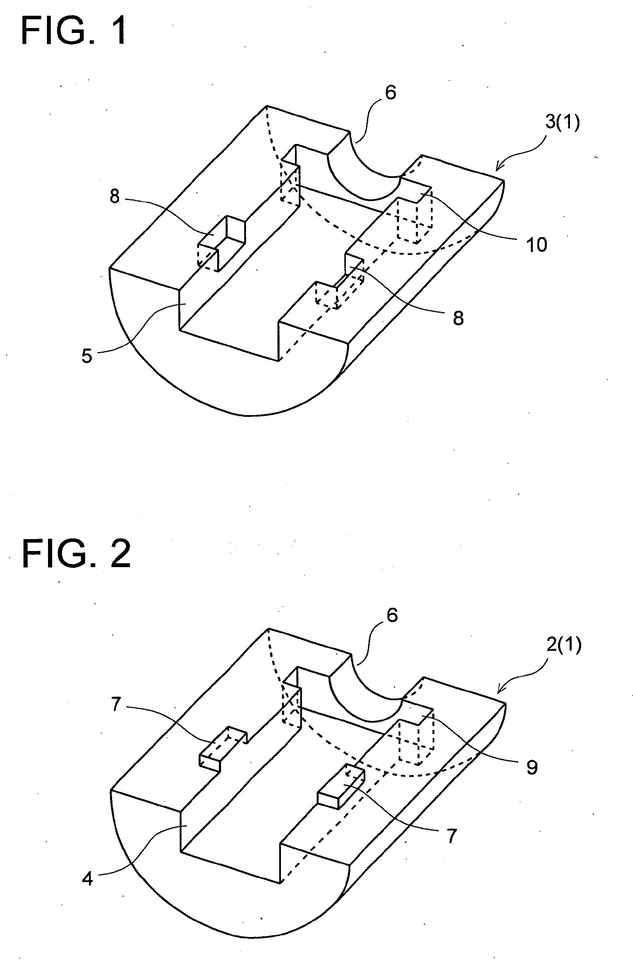

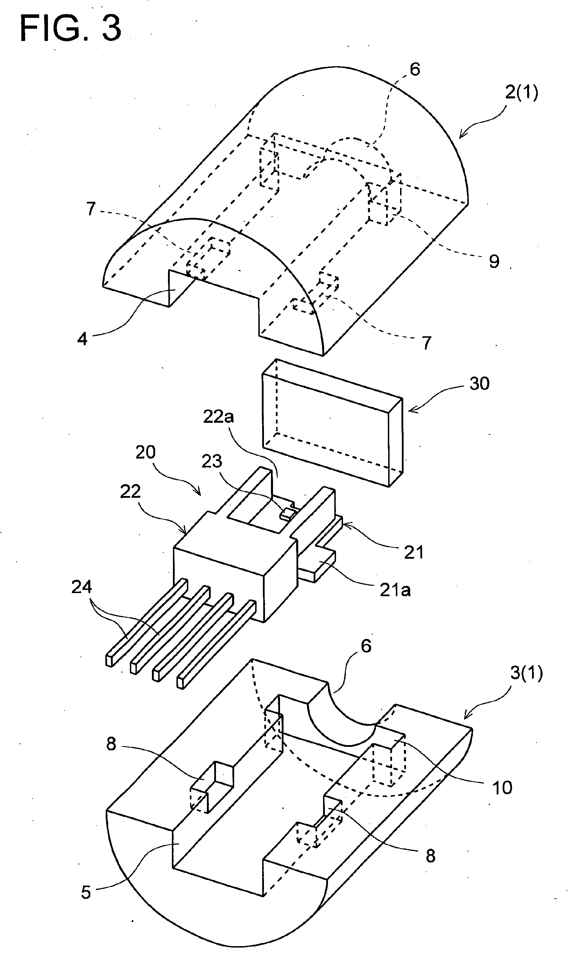

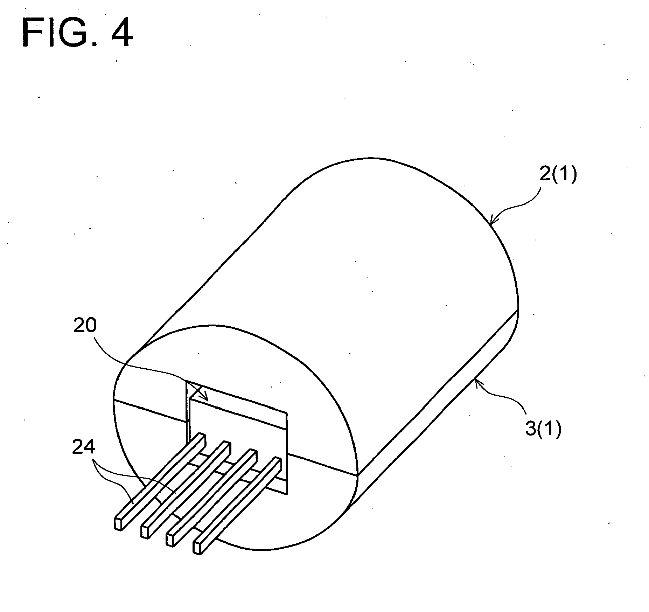

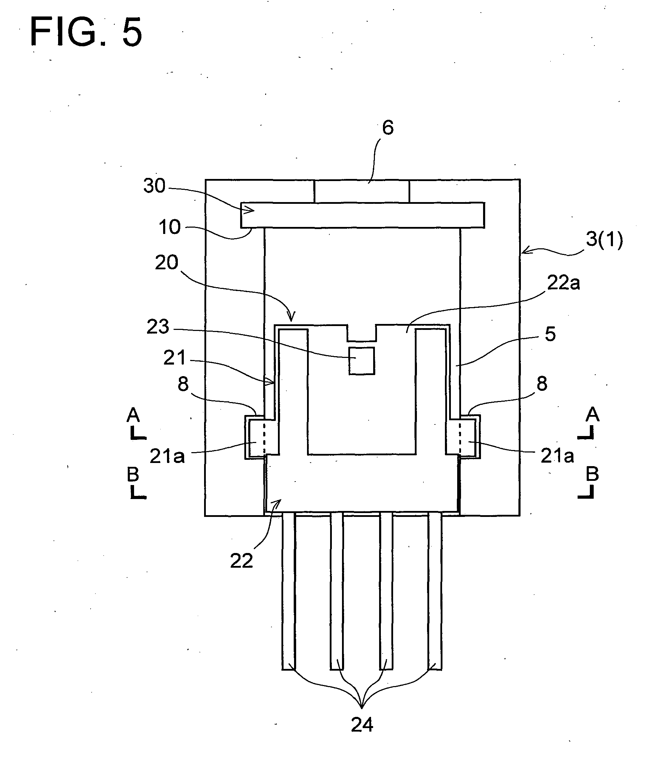

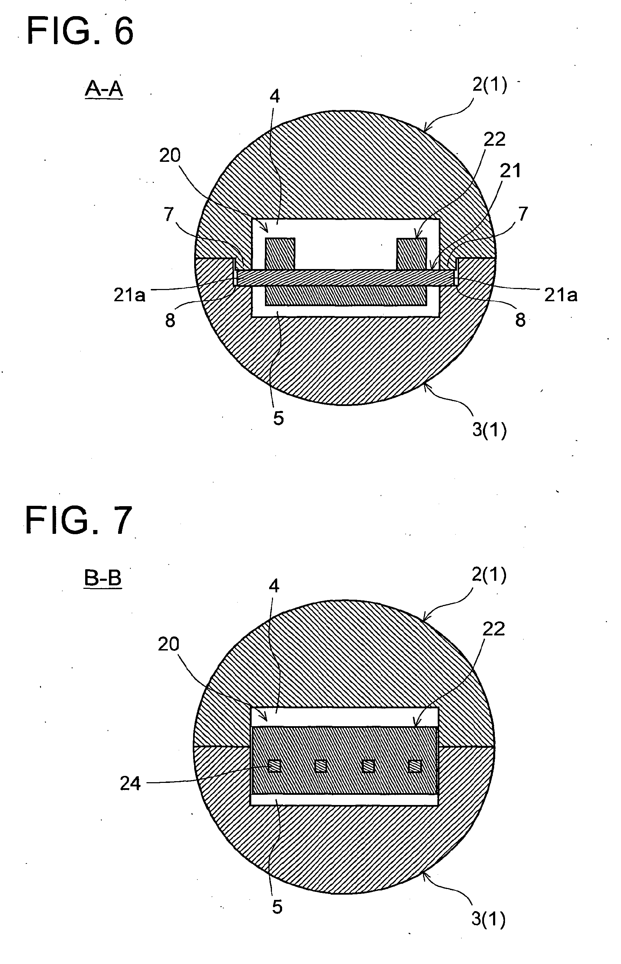

Hereinafter, embodiments of the present invention will be described in detail with reference to the accompanying drawings. First, the semiconductor laser holder of a first embodiment of the present invention will be described. Fig. 1 is a perspective view of the lower holder member constituting the semiconductor laser holder of the first embodiment. Fig. 2 is a perspective view of the upper holder member constituting the semiconductor laser holder. Fig. 3 is a perspective view showing the exploded state of the semiconductor laser holder. Fig. 4 is a perspective view showing the assembled state of the semiconductor laser holder. Fig. 5 is a top view showing the assembled state of the semiconductor laser holder, as seen through the upper holder member. Fig. 6 is a sectional view along line A-A shown in Fig. 5. Fig. 7 is a sectional view along line B-B shown in Fig. 5. Here, used as a semiconductor laser is a frame-type semiconductor laser 20 as shown in Figs. 11 and 12 described previously.

As shown in Figs. 1 to 7, the semiconductor laser holder 1 of this embodiment is composed of a pair of holder members, namely an upper holder member 2 and a lower holder member 3, that are fitted together from above and below. The upper and lower holder members 2 and 3 are both formed of metal having high thermal conductivity, and are formed individually by die-casting or machining. A preferred material for the upper and lower holder members 2 and 3 is zinc, because it offers satisfactorily high rigidity.

The upper and lower holder members 2 and 3 have housing depressions 4 and 5 formed in the fitting faces thereof so as to extend from the rear end to the front end thereof, and the semiconductor laser 20 is housed in those housing depressions 4 and 5. The laser light emitted from a laser element 23 through a light-exit opening 22a of the semiconductor laser 20 exits from the housing depressions 4 and 5 through an opening 6 at the front end thereof. On the other hand, from the rear end of the housing depressions 4 and 5, the lead pins 24 of the semiconductor laser 20 protrude.

In the fitting face of the lower holder member 3, depressions 8 are formed to accommodate the heat-sink projections 21a of the frame plate 21 that protrude from the left and right edges of the frame package 22 of the semiconductor laser 20. On the other hand, on the fitting face of the upper holder member 2, elevations 7 are formed so as to correspond to the depressions 8 of the lower holder member 3. The semiconductor laser 20 is housed in the housing depression 5 of the lower holder member 3, with the heat-sink projections 21a of the semiconductor laser 20 accommodated in the depressions 8 of the lower holder member 3. Then, when the upper holder member 2 is put on top, the elevations 7 fit into the depressions 8 of the lower holder member 3, and thus the upper and lower holder members 2 and 3 are fitted together. In this way, the heat-sink projections 21a are held between the roof faces of the elevations 7 of the upper holder member 2 and the floor faces of the depressions 8 of the lower holder member 3, and thus the semiconductor laser 20 is held inside the semiconductor laser holder 1.

The upper and lower holder members 2 and 3 fitted together are fixed together by being bonded together with adhesive applied to the fitting faces thereof. Alternatively, they may be fixed together by being fastened with a screw.

In addition, in this embodiment, in the housing depressions 4 and 5 of the upper and lower holder members 2 and 3, near the opening 6 at the front end, grooves 9 and 10 are formed so as to extend perpendicularly to the optical axis of the laser light emitted from the laser element 23 through the light-exit opening 22a of the semiconductor laser 20. In these grooves 9 and 10, a diffraction grating 30 is housed.

With the semiconductor laser holder 1 structured as described above, since the upper and lower holder members 2 and 3, in which the elevations 7 and the depressions 8 between which to hold the heat-sink projections 21a of the frame plate 21 of the semiconductor laser 20 are formed, are formed of metal having high thermal conductivity, the heat generated by the laser element 23 and conducted via the frame plate 21 to the heat-sink projections 21a is conducted further to the upper and lower holder members 2 and 3 themselves so as to be then dissipated to outside. Thus, it is possible to achieve satisfactory heat dissipation without spoiling it. In addition, the elevations 7 and the depressions 8 formed in the upper and lower holder members 2 and 3 serve to hold, between them, the heat-sink projections 2a, and also serve to position the upper and lower holder members 2 and 3 relative to each other.

Moreover, since the upper and lower holder members 2 and 3 are fixed together by being bonded together with adhesive applied to the fitting faces thereof, the semiconductor laser 20 is held stably. The same is true when they are fixed together by being fastened together with a screw. Furthermore, since the diffraction grating 30 is housed in the housing depressions 4 and 5 of the upper and lower holder members 2 and 3, near the opening 6, it is possible to prevent undesirable entry of dust and other foreign matter through the opening 6.

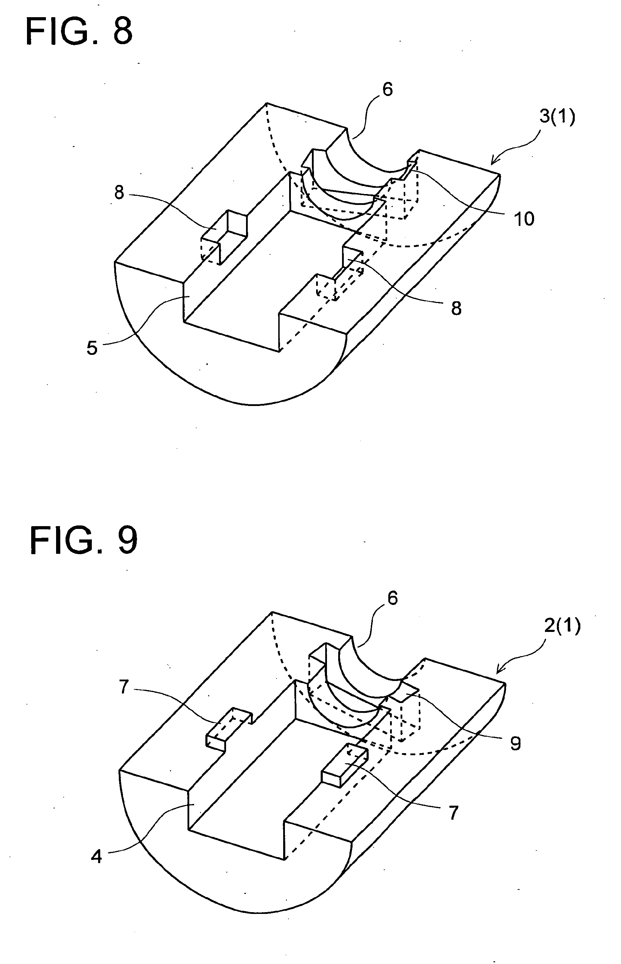

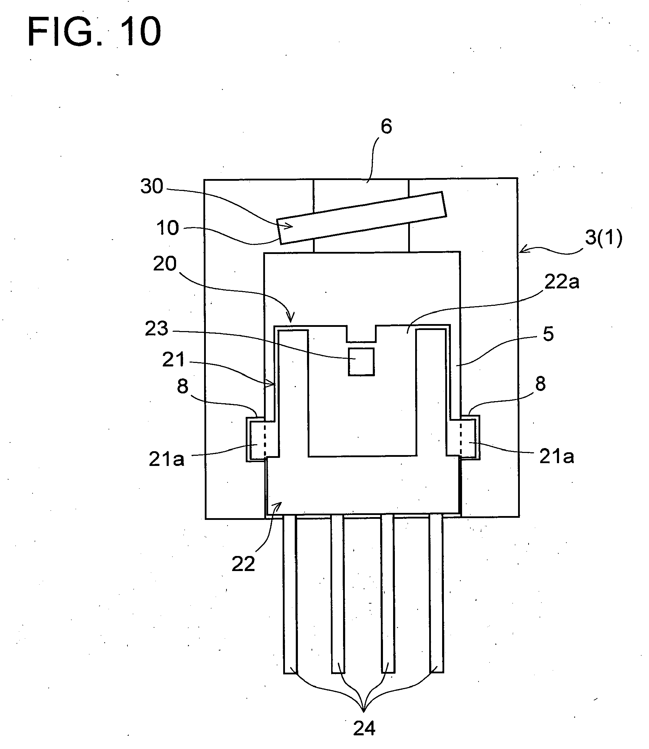

Next, a second embodiment of the present invention will be described with reference to Figs. 8 to 10. Fig. 8 is a perspective view of the lower holder member constituting the semiconductor laser holder of the second embodiment. Fig. 9 is a perspective view of the upper holder member constituting the semiconductor laser holder. Fig. 10 is a top view showing the assembled state of the semiconductor laser holder, as seen through the upper holder member. In these figures, such parts as have the same names and serve the same purposes as in Figs. 1 to 7 are identified with common reference numerals, and no overlapping explanations will be repeated.

The second embodiment is characterized in that it is so structured as to cope with a case where, as the semiconductor laser 20 in the first embodiment, a semiconductor laser is adopted that intrinsically has a large astigmatic difference. As shown in Figs. 8 to 10, in this embodiment, the grooves 9 and 10 formed in the upper and lower holder members 2 and 3 to house the diffraction grating 30 are inclined at a predetermined angle relative to the optical axis of the laser light emitted from the laser element 23 via the light-exit opening 22a of the semiconductor laser 20. That is, the diffraction grating 30 is so housed as to be inclined at a predetermined angle relative to the optical axis of the laser light.

With this structure, even when the semiconductor laser 20 adopted has a large astigmatic difference, the diffraction grating 30 arranged at an angle corrects for the astigmatic difference. Needless to say, it also prevents undesirable entry of dust and other foreign matter through the opening 6.

It should be understood that the embodiments specifically described above are not meant to limit in any way the manner the present invention is to be carried out, and therefore many modifications and variations are possible within the spirit of the present invention. For example, the diffraction grating 30 does not necessarily have to be provided inside the housing depressions 4 and 5 of the upper and lower holder members 2 and 3. In that case, a diffraction grating is separately provided on the base member of the pickup apparatus to which the semiconductor laser holder 1 is fitted. Even in that case, the laser element 23 of the semiconductor laser 20 housed inside the semiconductor laser holder 1 is surrounded by the upper and lower holder members 2 and 3, and is thereby kept dust-free.

## Claims

1. A semiconductor laser holder for holding a frame-type semiconductor laser (20) composed of a frame plate (21) formed of metal and having a laser element (23) mounted on a top face thereof and a frame package formed of resin, formed so as to surround the laser element (23) from front, rear, left and right sides thereof, and having a light-exit opening formed at a front end thereof to let laser light from the laser element (23) exit therethrough,
the semiconductor laser holder (1) comprising an upper holder member (2) and a lower holder member (3) formed of metal, fitted together from above and below, having housing depressions (4, 5) formed in fitting faces thereof to house the semiconductor laser (20), and having an opening at a front end thereof to let the laser light exit therethrough,
wherein the lower holder member (3) has depressions (8) formed in the fitting face thereof to accommodate heat-sink projections (21a) of the frame plate (21) protruding from left and right edges of the frame package of the semiconductor laser (20), and the upper holder member (2) has elevations (7) formed on the fitting face thereof to fit into the depressions (8) so as to hold the heat-sink projections (21 a) against floor faces of the depressions (8).

2. The semiconductor laser holder of claim 1,
wherein the upper and lower holder members (2, 3) are formed of zinc.

3. The semiconductor laser holder of claim 1 or 2,
wherein the upper and lower holder members (2, 3) that have been fitted together are fixed together by being bonded together with adhesive applied to the fitting faces thereof.

4. The semiconductor laser holder of claim 1 or 2,
wherein the upper and lower holder members (2, 3) that have been fitted together are fixed together by being fastened together with a screw.

5. The semiconductor laser holder according to any of the preceding claims,
wherein, in the housing depressions (4, 5) formed in the upper and lower holder members (2, 3), a diffraction grating (30) is housed near the opening (6).

6. The semiconductor laser holder of claim 5,
wherein the diffraction grating (30) is so housed as to be inclined at a predetermined angle relative to an optical axis of the laser light.
